# EUROPÄISCHE PATENTSCHRIFT

(11) **EP 1 163 508 B1**
(45) Veröffentlichungstag und Bekanntmachung des Hinweises auf die Patenterteilung: **11.12.2002**
(21) Anmeldenummer: 00943825.0
(22) Anmeldetag: 16.06.2000
(51) Int. Cl.: G01N 24/08, G01R 33/38, G01R 33/44

(54) **VORRICHTUNG ZUR UNTERSUCHUNG VON FLÄCHENWARE AUS POLYMEREN WERKSTOFFEN MIT EINGEBETTETEN TEXTILEN FESTIGKEITSTRÄGERN**
DEVICE FOR INSPECTING FLAT GOODS MADE OF POLYMERIC MATERIALS WITH EMBEDDED TEXTILE STRENGTH SUPPORTS
DISPOSITIF POUR EXAMINER DES ARTICLES PLATS A BASE DE MATIERES POLYMERES COMPORTANT DES SUPPORTS DE RESISTANCE TEXTILES ENROBES

(30) Priorität: 20.06.1999 DE 19928039
(43) Veröffentlichungstag der Anmeldung: 19.12.2001
(73) Patentinhaber: Intech Thüringen GmbH, 99880 Waltshausen (DE); Blümich, Bernhard, 52159 Roetgen (DE)
(72) Erfinder: BLÜMICH, Bernhard, 52159 Roetgen (DE); BRUDER, Michael, 22147 Hamburg (DE); GUERLIN, Thomas, 23730 Neustadt (DE); PRADO, Pablo, San Diego, CA 92104 (US)
(74) Vertreter: Metz, Siegfried
(86) Internationale Anmeldenummer: EP0005580
(87) Internationale Veröffentlichungsnummer: WO00079253

(56) Entgegenhaltungen:
- EP-A- 0 313 435
- US-A- 4 301 411
- US-A- 5 331 282
- B. BLÜMICH ET AL.: "The NMR-Mouse: Construction, Excitation, and Applications" MAGNETIC RESONANCE IMAGING, Bd. 16, Nr. 5/6, Juli 1998 (1998-07), Seiten 479-484, XP000918278
- G. ZIMMER, A. GUTHAUSEN, B. BLÜMICH: "Characterization of cross-link density in technical elastomers by the NMR-MOUSE" SOLID STATE NUCLEAR MAGNETIC RESONANCE, Bd. 12, Nr. 2-3, September 1998 (1998-09), Seiten 183-190, XP000918333
- RITCHEY W M ET AL: "APPLICATIONS OF MAGNETIC RESONANCE IMAGING TO MATERIALS RESEARCH" APPLIED SPECTROSCOPY REVIEWS,US,MARCEL DEKKER INC.270 MADISON AVENUE. NEW YORK, Bd. 29, Nr. 3/04, 1. August 1994 (1994-08-01), Seiten 233-267, XP000484820 ISSN: 0570-4928

## Beschreibung

Die Erfindung bezieht sich auf eine Vorrichtung zur Untersuchung von Flächenware aus polymeren Werkstoffen mit eingebetteten textilen Festigkeitsträgern.

Flächenware aus polymeren Werkstoffen mit textilen Festigkeitsträgern, die zur Verstärkung und Formgebung im polymeren Werkstoff eingebettet sind, ist bekannt. Flächenware aus solchen polymeren Werkstoffen, die Elastomere, thermoplastische Elastomere, Thermoplaste und Duroplaste umfassen, dienen insbesondere zum Einsatz in Dachbelägen, als Drucktücher, Fördergurte, Membranen sowie als zylindrische Flächenware in Luftfedern, Schläuchen und Kompensatoren.

Von Bedeutung sind Qualitätsbestimmungen für die Flächenware, vor allem Untersuchungen, mit denen der Verlauf der Festigkeitsträger im polymeren Werkstoff festgestellt werden kann. Bisher werden die Werkstoffe in folgender Weise untersucht: Zerstörende stochastische Untersuchungsmethoden, zerstörungsfrei mittels Röntgendurchstrahlungstechnik.

Aufgabe der Erfindung ist es, eine Vorrichtung zur Verfügung zu stellen, mit der die Flächenware möglichst vollständig hinsichtlich Anordnung und Verlauf der Festigkeitsträger im polymeren Werkstoff zerstörungsfrei untersuchbar ist. Insbesondere sollen nicht gewünschte Störstellen, z.B. ungleiche Abstände der Festigkeitsträger oder fehlende Festigkeitsträger, ermittelt werden können. Dabei soll durch die Untersuchungsmethode die Qualität der Flächenware nicht beeinträchtigt werden. Die Vorrichtung soll bei einfachem Aufbau mit gutem Kontrast arbeiten.

Diese Aufgabe wird gemäß Anspruch 1 durch Ausbildung eines Meßkörpers mit einer von NMR-MOUSE-Sonden gebildeten Meßebene zur Auflage der Flächenware zur kernmagnetischen Analyse gelöst. Zusätzliche Merkmale sind in den abhängigen Ansprüchen definiert.

NMR-MOUSE-Sonden (Nuclear Magnetic Resonance MObile Universal Surface Explorer) sind zur Materialanalyse in der Materialforschung bekannt, siehe G.Eidmann et al, "The NMR-MOUSE, a Mobil Universal Surface Explorer", Journal of Magnetic Resonance (J.Magn.Res.) A122, 1996, S. 104/109, sowie A.Guthausen et al, "Analysis of Polymer Materials by Surface NMR via the MOUSE", J.Magn.Reson. A129, 1997, S.001/007, und A.Guthausen et al, "NMR-Bildgebung und Materialforschung", Chemie unserer Zeit, 1998, S.73/82. Mit NMR-MOUSE-Sonden wird durch magnetische Resonanz (NMR) in einem der Oberfläche der Sonde nahen Umgebungsbereich ein NMR-Signal erzeugt und gemessen, das zur Charakterisierung der Eigenschaften von im oberflächennahen Bereich der NMR-MOUSE-Sonde angeordneten Werkstoffen ausgenutzt wird., Flächenware aus polymeren Werkstoffen mit textilen Festigkeitsträgern besteht im Sinne der praktisch durchführbaren Messung der kernmagnetischen Resonanz des Wasserstoffkerns 1H (1H-NMR) aus signalgebenden Bereichen, nämlich dem polymeren Werkstoff, und einem Material, das - wie die textilen Festigkeitsträger - wenig bis kein Signal abgibt. Zur Untersuchung der Position der textilen Festigkeitsträger im polymeren Werkstoff ist daher schon die unter üblichen experimentellen Bedingungen wenig anspruchsvolle Abbildung der Spindichte ausreichend. Ein Einführen von Relaxationskontrast ist zur Auswertung der Untersuchungsergebnisse nicht notwendigerweise erforderlich, aber auch nicht störend.

Neben dem üblicherweise gemessenen Kern 1H kommt für die Untersuchung der Flächenware mit NMR-MOUSE-Sonden auch der Kern 19F in Betracht. Liegt 19F nur im Material der textilen Festigkeitsträger vor, so können die textilen Festigkeitsträger durch 19F-NMR direkt abgebildet werden.

Die Analyse der Flächenware aus polymerem Werkstoff mit textilen Festigkeitsträgern mit NMR-MOUSE-Sonden ist besonders vorteilhaft, weil 1) die Messempfindlichkeit der NMR-MOUSE-Sonden bei geringen Tiefen des meßempfindlichen Volumens der Sonde (z. B. 0 bis 3 mm) besonders hoch ist und 2) weiche Materie wie Polymere für die NMR-Bildgebung besonders geeignet ist. Verzichtet man auf ein homogenes magnetisches Polarisierungsfeld B0 und ein homogenes Hochfrequenzfeld B1, können die NMR-MOUSE-Sonden im Verhältnis zu üblichen NMR-Geräten klein gebaut werden.

In weiterer Ausbildung der Erfindung nach Anspruch 2 sind die NMR-MOUSE-Sonden in der Meßebene sich gegenseitig überlappend angeordnet, um die Flächenware möglichst umfassend in einer Richtung im Material untersuchen zu können, insbesondere derart, daß sich ihre meßempfindlichen Volumenbereiche in dieser Richtung überlappen, Anspruch 3.

Wird nur die ¹H-Dichte abgebildet, so kann die Messung bei erhöhter Temperatur erfolgen, bei der sich die Gummimoleküle thermisch stärker bewegen. Die Flächenware wird hierzu warm untersucht. Die Untersuchung kann noch während und/oder unmittelbar nach dem Herstellungsprozeß, der Vulkanisation, erfolgen. Die Untersuchungstemperatur wird von der Curie-Temperatur des Materials begrenzt, die Temperatur der Flächenware muß unterhalb der Curie-Temperatur liegen. Dem mit dieser Messung verbundenen Gewinn an Messempfindlichkeit kann zwar ein Verlust an Kontrast durch die verschiedenen NMR-Relaxationszeiten gegenüber stehen, eine Erhöhung der Meßempfindlichkeit ist jedoch für die hier zu untersuchende Flächenware von größerer Bedeutung.

Die Erfindung und weitere Ausgestaltungen der Erfindung werden nachfolgend anhand von Ausführungsbeispielen, die in der Zeichnung schematisch wiedergegeben sind, näher erläutert. Die Zeichnung zeigt im einzelnen
- Figur 1: zylindrischer Meßkörper mit NMR-MOUSE-Sonden
- Figur 2: Ausschnitt eines flächigen Meßkörpers mit NMR-MOUSE-Sonden
- Figur 3: Aufbau einer NMR-MOUSE-Sonde mit
Figur 3a: Aufsicht auf eine NMR-MOUSE-Sonde aus Richtung a nach Figur 3b,
Figur 3b: Längsschnitt durch die NMR-MOUSE-Sonde gemäß Schnittlinie b nach Figur 3a
- Figur 4: Meßbeispiel

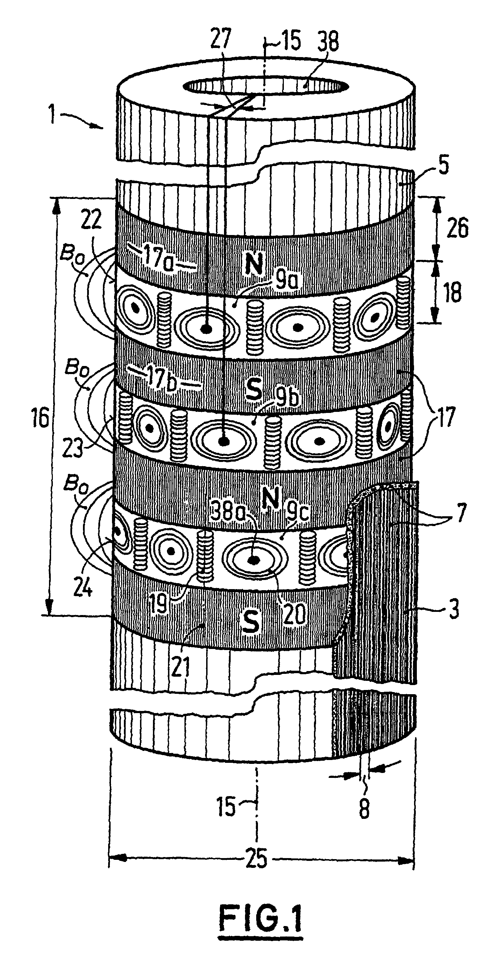

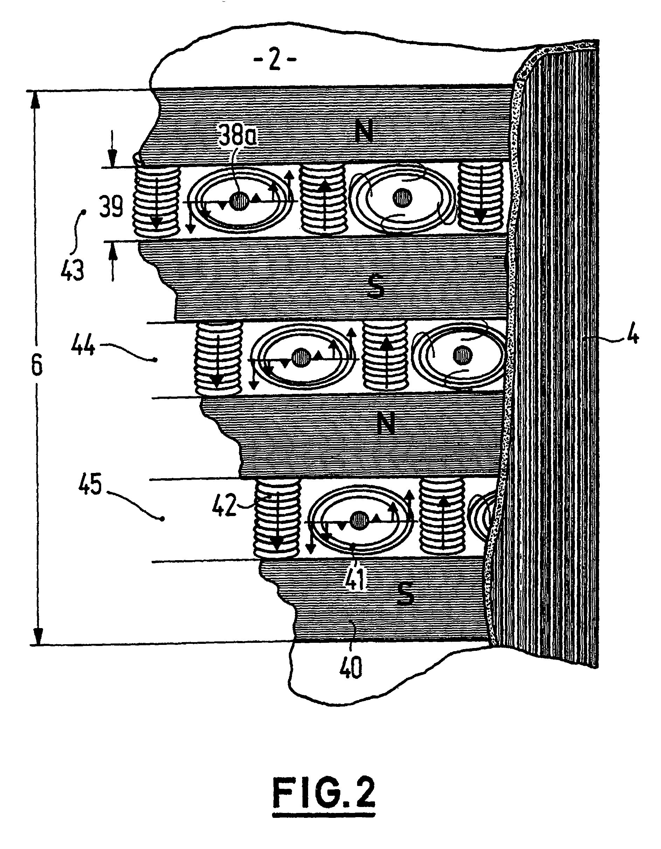

Figuren 1 und 2 zeigen Vorrichtungen zur Untersuchung von Flächenware aus polymerem Werkstoff mit Meßkörpern 1 und 2, die NMR-MOUSE-Sonden aufweisen. In den Ausführungsbeispielen dienen die Vorrichtungen zur Untersuchung eines pneumatisch belastbaren Bauteils aus natürlichem oder synthetischem Kautschuk, dem zur Erhöhung seiner Belastbarkeit textile Festigkeitsträger beigefügt sind. Die textilen Festigkeitsträger im polymeren Material bestehen in den Ausführungsbeispielen aus Aramidfasem oder Polyamidfasern. Geeignet sind auch Polyester, Mineralfasern (z.B. Glasfaser), Kohlefasern, Fasern aus azetylisiertem Polyvinylalkohol, Reonfasern (halbsynthetische Fasern z.B. mit Zellulose) oder beispielsweise Baumwolle. Bei den im polymeren Material eingebetteten Festigkeitsträgern handelt es sich um Fasern aus einem Werkstoff, der gegenüber dem polymeren Grundmaterial, in dem sie eingebettet sind, eine geringere 1H - oder 19F - Dichte hat oder der andere NMR-Relaxationszeiten aufweist.

Der Meßkörper 1, der zylindrisch geformt ist, ist insbesondere zum Test schlauchförmiger Flächenware 3 bestimmt, mit dem Meßkörper 2 sind ebene Materialbahnen 4 als Flächenware untersuchbar. Zur Untersuchung wird die Flächenware beim Meßkörper 1 auf dessen Zylinderoberfläche 5 auf eine zylindrische Meßebene aufgezogen, beim Meßkörper 2 auf dessen plane Meßebene 6 aufgelegt. Von der schlauchförmigen Flächenware 3 und der zu testenden Materialbahn 4 sind in Figuren 1 und 2 nur Teilstücke dargestellt.

Der polymere Werkstoff wird von Festigkeitsträgern 7 durchzogen, deren Lage in der Flächenware 3 bzw. 4 in der Zeichnung nur schematisch wiedergegeben ist. In den Ausführungsbeispielen durchziehen die Festigkeitsträger 7 das polymere Material mit Abstand 8 im wesentlichen parallel zu einander in einer vorgegebenen Richtung, im Ausführungsbeispiel parallel zur Längserstreckung der schlauch- oder bahnförmigen Flächenware 3 bzw. 4. Der Abstand 8 zwischen den parallel verlaufenden Festigkeitsträgern 7 beträgt ca. 0,5 bis 1 mm.

Die im Werkstoff eingebetteten Festigkeitsträger können jedoch auch in anderer Weise als in Figuren 1 und 2 gezeigt angeordnet sein, beispielsweise das Material netzförmig durchziehen oder sich überkreuzend verlaufen.

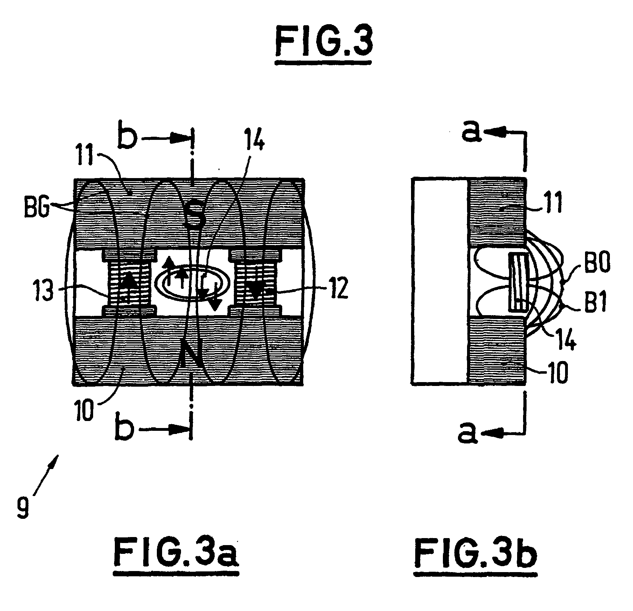

Zur Untersuchung der Anordnung und des Verlaufs der Festigkeitsträger im polymeren Werkstoff , insbesondere zur Feststellung von nicht gewünschten Störstellen, z.B. ungleichem Fadenabstand oder fehlenden Fäden, die die für den Anwendungsfall erforderliche Verstärkung der Festigkeit des Materials beeinträchtigen, dienen in den Meßkörpern 1 und 2 NMR-MOUSE-Sonden. Der grundsätzliche Aufbau einer solchen NMR-MOUSE-Sonde ist in Figur 3 (Figuren 3a, 3b) gezeigt.

Eine NMR-MOUSE-Sonde weist zur Polarisation der kernmagneten Momente im zu untersuchenden Material und zur Erzeugung von Meßsignalen räumlich inhomogene Magnetfelder auf. Wie aus Figur 3 ersichtlich ist, befinden sich bei einer NMR-MOUSE-Sonde 9 zwischen zwei entgegengesetzt magnetisierten Permanentmagneten 10, 11 mit Permanentmagnetpolen N und S zwei Gradientenspulen 12,13 sowie zwischen den Gradientenspulen eine Hochfrequenzspule 14. Dem statischen Polarisationsfeld B0, das zwischen den Permanentmagnetpolen erzeugt wird, ist mittels der Hochfrequenzspule 14 in zeitlichem Abstand pulsierend ein magnetisches Meßfeld B1 als magnetischer Anteil eines Hochfreqenzfeldes überlagerbar, das mit der Hochfrequenzspule als Bestandteil eines elektrischen Schwingkreises gebildet und empfangen wird. Unter "Pulsen" des magnetischen Meßfeldes B1 wird verstanden, daß das Magnetfeld in einem vorgegebenen Zeittakt durch Anregen der Hochfrequenzspule über einen kurzen Zeitraum stoßweise erzeugt wird. Mit den Gradientenspulen 12,13 wird - ebenfalls gepulst - dem Magnetfeld zusätzlich ein magnetisches Gradientenfeld BG überlagert. In Figur 3a sind die Feldlinien des Gradientenfeldes BG schematisch eingetragen. Form und Größe des Umgebungsvolumens, das in der äußeren Umgebung der NMR-MOUSE-Sonde kernmagnetisch impliziert und durch Messen der Echosignale zu detektieren ist und den meßempfindlichen Volumenbereich darstellt, ist für jede Sonde einerseits durch die spezifische Bandbreite der magnetischen Hochfrequenzanregung und andererseits durch die orthogonalen Komponenten beider Magnetfelder B0 und B1 definiert. Der Verlauf der magnetischen Feldlinien und damit die Größe des signalgebenden Volumenbereichs kann durch entsprechendes Dimensionieren und Anordnen der Permanentmagnete und der Spule des elektrischen Hochfrequenzschwingkreises verändert werden.

Zum permanentmagnetischen Polarisationsfeld B0 (Grundfeld) wird mittels der Gradientensspulen 12, 13 somit zusätzlich ein Gradientenfeld BG mit einem Feldgradienten tangential zur äußeren Oberfläche der NMR-MOUSE-Sonde 9 und senkrecht zum Polarisationsfeld B0 erzeugt. Dieses Zusatzfeld BG wird zur Erzeugung der Ortsauflösung (Phasenkodierung der Ortsinformation) in zeitlichem Abstand gepulst. Die Hochfrequenzspule 14 ist in der Weise angeordnet, daß die Feldlinien des Polarisationsfeldes B0 und die Feldlinien des durch die Hochfrequenzspule erzeugten magnetischen Meßfeldes B1 im messempfindlichen Volumenbereich senkrecht aufeinander stehen. Die orthogonalen Komponenten der beiden Magnetfelder B0 und B1 indizieren das Meßsignal. Für Anregung und Detektion des Messignals wird die gleiche Hochfrequenzspule verwendet.

Im Ausführungsbeispiel nach Figur 1 sind auf dem zylindrischen Meßkörper 1 mit Zylinderachse 15 im Meßbereich 16 der zylindrischen Meßebene mehrere Permanentmagnetringe 17 vorgesehen, die radial polarisiert sind und in Richtung der Zylinderachse 15 gesehen mit Abstand 18 hintereinander um die Zylinderachse 15 axial zentriert angeordnet sind. Jeweils benachbarte Permanentmagnetringe 17a, 17b sind entgegengesetzt polarisiert: So ist neben dem Permanentmagnetring 17a, dessen Magnetfeld in magnetischer Nord/Süd-Richtung radial von Außen nach Innen gerichtet ist (der magnetische Nordpol N des Permanentmagnetringes 17a wird von der äußeren Ringfläche gebildet), im Abstand 18 ein Permanentmagnetring 17b mit entgegengesetzt gerichtetem Magnetfeld angebracht (die äußere Ringfläche des Permanentmagnetringes 17b bildet den magnetischen Südpol S). Auf diese Weise werden in der äußeren Umgebung des Meßbereichs 16 auf dem zylindrischen Meßkörpers 1 jeweils zwischen benachbarten Permanentmagnetringen 17 auf der Zylinderoberfläche 5 torusartig rotationssymmetrische Permanentmagnetfelder B0 erzeugt, mit denen das auf der Zylinderoberfläche des Meßkörpers aufliegende Material durchdrungen werden kann.

Am Rande des Meßkörpers 1 sind in Figur 1 in der zylindrischen Meßebene schematische Schnitte durch die gebildeten rotationssymmetrischen Permanentmagnetringfelder B0 angegeben.

In der zylindrischen Meßebene am Meßkörper 1 sind zwischen den mit Abstand 18 angeordneten Permanentmagnetringen 17 elektrische Gradientenspulen 19 und Hochfrequenzspulen 20 vorgesehen, die ebenfalls zu einem Ring aneinander gesetzt sind. Mit den Hochfrequenzspulen ist dem Permanentmagnetringfeld B0 der Permanentmagnetringe ein gepulstes magnetisches Meßfeld B1 als magnetischer Anteil eines Hochfrequenzfeldes überlagerbar, mit den Gradientenspulen 19 wird - ebenfalls gepulst - im messempfindlichen Volumenbereich zusätzlich ein Gradientenfeld BG in tangentialer Richtung zur Zylinderoberfläche 5 und senkrecht zum Permanentmagnetringfeld B0 erzeugt.

Wie aus Figur 1 ersichtlich ist, sind am Meßkörper 1 die zwischen den Permanentmagnetringen 17 angeordneten Gradientenspulen 19 - der achsparallen Ausrichtung der Permanentmagnetringe 17 entsprechend - mit ihren Spulenachsen 21 parallel zur Zylinderachse 15 verlaufend angeordnet. Bei dieser Ausrichtung der Gradientenspulen läßt sich das Permanentmagnetfeld B0 durch die mit den Gradientenspulen erzeugten Gradientenfelder BG maximal beeinflussen. Jeweils von benachbarten Gradientenspulen 19 begrenzte Sektorbereiche der Permanentmagnetringe 17 bilden zusammen mit diesen Gradientenspulen und der zwischen den Gradientenspulen 19 eingesetzten Hochfrequenzspule 20 eine NMR-MOUSE-Sonde. Jede Gradientenspule ist somit jeweils zwei zueinander benachbarten NMR-MOUSE-Sonden zugeordnet.

Im Ausführungsbeispiel nach Figur 1 sind in der Meßebene auf dem zylindrischen Meßkörper 1 vier Permanentmagnetringe 17 in Achsrichtung der Zylinderachse 15 aufeinanderfolgend angeordnet. Auf der Zylinderoberfläche 5 des Meßkörpers 1 werden somit im Meßbereich 16 von den radial polarisierten Permanentmagnetringen 17 mit jeweils entgegengesetzter Magnetfeldrichtung benachbarter Permanentmagnetringe drei torusartige rotationssymmetrische Polarisationsfelder B0 erzeugt. Zwischen den Permanentmagnetringen 17 sind drei Sondenringe 22, 23, 24 mit Gradienten- und Hochfrequenzspulen 19 bzw. 20 vorgesehen. In Figur 1 sind die NMR-MOUSE-Sonden, die auf diese Weise auf jedem Sondenring ausgebildet werden und auf jedem Ring benachbart senkrecht zum Verlauf der Festigkeitsträger angeordnet sind, mit Bezugszeichen 9a für die NMR-MOUSE-Sonden im Sondenring 22, mit Bezugszeichen 9b für die NMR-MOUSE-Sonden im Sondenring 23 und mit Bezugszeichen 9c für die NMR-MOUSE-Sonden im Sondenring 24 angegeben.

Im Ausführungsbeispiel ist die Form und Größe des Meßkörpers 1 den Abmessungen der im Anwendungsfall zu untersuchenden Flächenware angepaßt. Die NMR-MOUSE-Sonden sind derart ausgelegt, daß Flächenware untersuchbar ist, deren textile Festigkeitsträger wenigstens ca. 0,1 mm stark sind und in einer Tiefe zwischen etwa 0,2 bis 5 mm unterhalb der Oberfläche im polymeren Werkstoff eingebettet sind. Im Ausführungsbeispiel wird ein pneumatisch belastbarer, schlauchförmiger Elastomerbelag, der eine Stärke von 2 mm aufweist, mit Festigkeitsträgern aus 0,2 bis 0,5 mm starken Polyamidfasern untersucht, die den polymeren Werkstoff mittig in einer Tiefe von 1 mm in Längserstreckung des Schlauchs parallel zueinander im Abstand von 0,5 bis 1 mm durchziehen. Der Durchmesser 25 des Meßkörpers 1 mit den Permanentmagnetringen 17 beträgt dem Schlauchdurchmesser angepaßt 80 mm. Die Ringstärke 26 der Permanentmagnetringe parallel zur Zylinderachse 15 beträgt 20 mm, der Abstand 18 zwischen den Permanentmagnetringen 17 zur Aufnahme der Gradienten- und Hochfrequenzspulen 19 bzw. 20 ist 13 mm lang. Insgesamt sind auf dem Umfang des Meßkörpers 1 im Ausführungsbeispiel pro Ring 22 bis 24 12 NMR-MOUSE-Sonden verteilt.

Die NMR-MOUSE-Sonden 9a, 9b, 9c sind auf dem Meßkörper 1 in den Ringebenen der drei Sondenringe 22 bis 24 in Richtung der Zylinderachse 15 gesehen vom Sondenring 22 bis zum Sondenring 24 jeweils um einen Winkel 27 gegeneinander versetzt angeordnet, damit sich die meßempfindlichen Volumenbereiche der NMR-MOUSE-Sonden 9a, 9b, 9c mit dem Ziel überlappen, den schlauchförmigen Werkstoff im Meßbereich 16 möglichst über den gesamten Schlauchumfang abzutasten. Der parallele Verlauf der textilen Festigkeitsträger im polymeren Werkstoff läßt sich auf diese Weise vollständig erfassen.

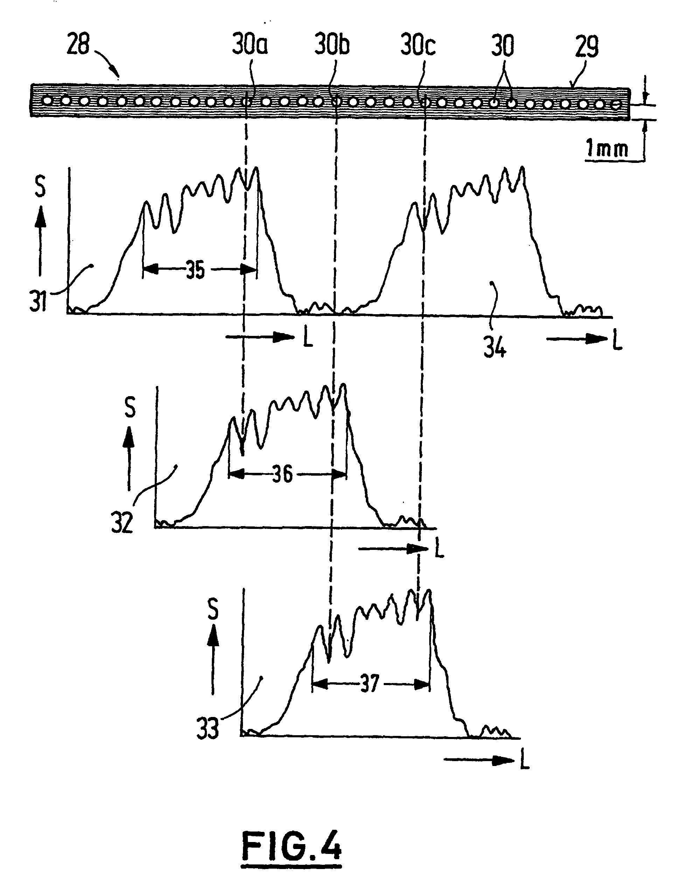

Zur Erläuterung von Überlappung und winkelversetzter Anordnung der NMR-MOUSE-Sonden 9a, 9b, 9c von Sondenring zu Sondenring sind in Figur 4 ein Querschnitt der von den Sonden untersuchten Flächenware 28 aus polymeren Werkstoff 29 und im schlauchförmigen Werkstoff in dessen Längserstreckung parallel zur Zylinderachse 15 und parallel zu einander verlaufenden textilen Festigkeitsträgern 30 sowie - dem von den NMR-MOUSE-Sonden 9a, 9b, 9c jeweils untersuchten Werkstoffbereich zugeordnet - vier schematisierte Meßprotokolle 31 bis 34 von vier NMR-MOUSE-Sonden wiedergegeben. In den Meßprotokollen werden auf der Ordinate die gemessenen Werte der Signalamplitude S in Abhängigkeit von der Werkstoffbreite L auf der Abszisse angegeben. Die Werkstoffbreite L wird von den NMR-MOUSE-Sonden beim Messen abgetastet.

Der polymere Werkstoff mit den textilen Festigkeitsträgern besteht im Sinne der NMR-Analyse hinsichtlich der zu bestimmenden Konzentration des kemmagnetisch zu polarisierenden Kerns 1H einerseits aus solchen Materialbereichen, die ein starkes NMR-Signal (aufgrund starker 1 H- oder 19F-Dichte oder langer transversaler Relaxationszeit) abgeben, nämlich den Bereichen, die nur aus polymeren Werkstoff bestehen, im Ausführungsbeispiel aus elastomeren Material, und andererseits aus solchen Materialbereichen, von denen wenig bis keine Signale ausgehen, nämlich Bereichen, in denen im Elastomer textile Festigkeitsträger verlaufen, im Ausführungsbeispiel Polyamidfasern. Aufgrund dieser sehr unterschiedlichen kernmagnetischen Eigenschaften der Materialbereiche ist aus den Meßprotokollen die Lage der Festigkeitsträger 30 im polymeren Werkstoff 29 am Rückgang der Signalamplitude S und somit durch Einschnitte im Meßwertverlauf über der Meßlänge L feststellbar. In Figur 4 ist die Zuordnung zwischen der Lage der Festigkeitsträger im polymeren Werkstoff und den erhaltenen Meßwerten dargestellt.

Aus den Meßprotokollen 31 bis 34 in Figur 4 ist auch ersichtlich, daß der relevante meßempfindliche Volumenbereich einer NMR-MOUSE-Sonde auf einen Kernbereich beschränkt ist, der kleiner bemessen ist als der Raum, der von einer NMR-MOUSE-Sonde auf einem Sondenring zwischen zwei Gradientenspulen 19 eingenommen wird. In Figur 4 sind in den Meßprotokollen als charakteristische Größe für die meßempfindlichen Volumenbereiche 35, 36, 37 der drei NMR-MOUSE-Sonden 9a, 9b, 9c die für die Analyse der Flächenware auswertbaren Intervalle eingetragen und mit den Bezugszeichen der Volumenbereiche gekennzeichnet. Außerhalb dieser meßempfindlichen Volumenbereiche 35, 36, 37 verbleiben bei den NMR-MOUSE-Sonden aufgrund ihres technischen Aufbaues Toträume, die für die Messung nicht nutzbar sind. Insofern lassen sich also mit nur auf einem Sondenring angeordneten NMR-MOUSE-Sonden nicht ohne weiteres Analysenergebnisse über den gesamten Umfang des auf der zylindrischen Meßebene im Meßbereich 16 aufliegenden Werkstoffs erhalten, die meßempfindlichen Volumenbereiche benachbart angeordneter NMR-MOUSE-Sonden schließen nicht lückenlos aneinander an.

Im Ausführungsbeispiel nach Figur 1 werden diese Toträume der einzelnen NMR-MOUSE-Sonden durch gegenseitiges Versetzen der Sonden von Sondenring zu Sondenring überbrückt. Die NMR-MOUSE-Sonden in einem Sondenring sind gegenüber den NMR-MOUSE-Sonden in einem benachbarten Sondenring winkelversetzt angeordnet, im Ausführungsbeispiel um den Winkel 27 derart versetzt, daß zumindest der äußerste Festigkeitsträger, der vom meßempfindlichen Volumenbereich einer NMR-MOUSE-Sonde gerade noch erfaßt ist, auch in den meßempfindlichen Volumenbereich der versetzt angeordneten NMR-MOUSE-Sonde im benachbarten Sondenring fällt. Durch diese doppelte Messung des jeweils äußeren Festigkeitsträgers im Randbereich des meßempfindlichen Volumens wird jeweils ein verifizierbarer Anschluß der Meßwerte der einzelnen NMR-MOUSE-Sonden zur vollständigen Analyse der Flächenware und des Verlaufs und gegenseitigen Abstands 8 der Festigkeitsträger im polymeren Werkstoff über den gesamten Umfang im Meßbereich 16 des Meßkörpers 1 geschaffen. In Figur 4 wird der Festigkeitsträger 30a sowohl vom meßempfindlichen Volumenbereich 35 der NMR-MOUSE-Sonde 9a im Sondenring 22 (siehe Figur 1), als auch vom meßempfindlichen Volumenbereich 36 der NMR-MOUSE-Sonde 9b im Sondenring 23 erfaßt. In gleicher Weise sind die NMR-MOUSE-Sonden 9b und 9c in den Sondenringen 23 und 24 bezüglich des Festigkeitsträgers 30b gegeneinander versetzt angeordnet, der Festigkeitsträger 30b wird sowohl im Randbereich des meßempfindlichen Volumenbereichs 36 als auch im Randbereich des meßempfindlcihen Volumenbereichs 37 gemessen. Der äußere Festigkeitsträger 30c, der von der NMR-MOUSE-Sonde 9c als letzter abgetastet wird, wird schließlich wieder zugleich von einer NMR-MOUSE-Sonde 9a im Sondenring 22 registriert. So ergibt sich beim Ausführungsbeispiel nach Figur 1 ein vollständiges Bild des Werkstoffquerschnitts über den gesamten Umfang der schlauchförmigen Flächenware.

Im Ausführungsbeispiel sind bei gleicher Ausbildung der NMR-MOUSE-Sonden die Winkel 27 zur Versetzung der Sonden gleich groß bemessen. Selbstverständlich kann der Winkel 27 für das Überlappen der NMR-MOUSE-Sonden auch kleiner gewählt werden als im Ausführungsbeispiel angegeben. Bei kleinerem Winkel werden dann sicherheitshalber von den jeweils versetzt zueinander angeordneten NMR-MOUSE-Sonden mehrere Festigkeitsträger im Randbereich des meßempfindlichen Volumenbereichs überlappend gemessen.

Die NMR-MOUSE-Sonden sind wechselweise ansteuerbar ausgebildet, so daß nach jeder Messung mit einer der NMR-MOUSE-Sonden während der im Verhältnis zur Messzeit langen Signalaufbauzeit (Signalaufbauzeit ca. 25 ms, Messzeit ca. 300 µs) der größte Teil der Gerätehardware, die zur Ansteuerung der Gradienten- und Hochfrequenzspulen benötigt wird, bereits für die Aufnahme eines weiteren Datenpunktes mit einer anderen der NMR-MOUSE-Sonden eingesetzt werden kann. Dies verkürzt die insgesamt zur Analyse des Werkstoffs erforderliche Untersuchungszeit. Hierzu sind schnelle Schalter erforderlich, die nicht nur zum Umschalten zwischen Senden und Empfangen an einer Sonde, sondern auch zum Umschalten zwischen den Sonden geeignet sind.

Jeweils im Zentrum einer Hochfrequenzspule 20 öffnen sich im Ausführungsbeispiel Mündungen 38a eines im Meßkörper 1 zentral verlaufenden Luftkanals 38, der mit Über- und Unterdruck beaufschlagt werden kann. Zur Untersuchung und Messung des Materials wird die schlauchförmige Flächenware 3, die auf der Zylinderoberfläche 5 des Meßkörpers 1 aufliegt und die Zylinderoberfläche umschließt, durch Unterdruck auf die zylindrische Meßebene gezogen, der Weitertransport der Flächenware geschieht bei Überdruck und von der Zylinderoberfläche gelöster Flächenware.

Der in Figur 2 ausschnittsweise gezeigte Meßkörper 2 für ebene Materialbahnen 4 ist analog zum Meßkörper 1 ausgebildet. Statt einer zylindrischen Meßebene ist hier eine plane Meßebene 6 vorgesehen, die von im Abstand 39 zu einander angeordneten blockförmigen Permanentmagneten 40 mit ebenen Polflächen N bzw. S ausgebildet ist. Zwischen den Permanentmagneten 40 sind Hochfrequenz- und Gradientenspulen 41, 42 eingesetzt. Der Meßkörper 2 weist vier entgegengesetzt polarisierte Permanentmagnetblöcke 40 mit drei Sondenzonen 43, 44, 45 auf, in denen die NMR-MOUSE-Sonden wieder gegeneinander versetzt so angeordnet sind, daß die Struktur der als Flächenware 4 zu untersuchenden ebenen Materialbahnen im Meßbereich des Meßkörpers 2 vollständig erfaßbar ist.

Die in den Ausführungsbeispielen verwendeten Permanentmagnete zur Erzeugung der Polarisationsfelder B0 lassen sich durch Elektromagnete oder auch supraleitende oder hochtemperatursupraleitende Magnete ersetzen. Die eingesetzten Gradientenspulen ermöglichen für die auf den Meßkörpern aufliegende Flächenware in den Ausführungsbeispielen eine eindimensionale Ortsauflösung in tangentialer Richtung auf den Meßebenen. Mit weiteren Gradientenspulen kann die Messung auf zweidimensionale Ortsauflösung erweitert werden.

### Bezugszeichenliste

Meßkörper 1, 2
schlauchförmige Flächenware 3
ebene Materialbahnen als Flächenware 4
Zylinderoberfläche 5
Meßebene 6
Festigkeitsträger 7
Abstand 8 der Festigkeitsträger 7
NMR-MOUSE-Sonde 9
Permanentmagnete 10, 11
Gradientenspule 12,13
Hochfrequenzspule 14
Zylinderachse 15
Meßbereich 16 des Meßkörpers 1
ringförmige Permanentmagnete 17, 17a, 17b
Abstand 18 zwischen Permanentmagnetringen 17
Gradientenspule 19
Hochfrequenzspule 20
Spulenachse 21
Sondenringe 22, 23, 24
Durchmesser 25 des Meßkörpers 1
Ringstärke 26
Winkel 27
Flächenware 28
polymerer Werkstoff 29
Festigkeitsträger 30, 30a, 30b, 30c
Meßprotokolle 31, 32, 33, 34
meßempfindliche Volumenbereiche 35, 36, 37
Polarisationsfeld B0
magnetisches Meßfeld B1
Gradientenfeld BG
Luftkanal 38, Mündungen 38a
Abstand 39
blockförmige Permanentmagnete 40
Hochfrequenzspule 41
Gradientenspule 42
Sondenzonen 43, 44, 45

## Patentansprüche

1. Vorrichtung zur Untersuchung von Flächenware aus polymerem Werkstoff mit eingebetteten textilen Festigkeitsträgern, **dadurch gekennzeichnet, daß** zur kernmagnetischen Analyse der Flächenware auf einem Meßkörper (1,2) eine von NMR-MOUSE-Sonden (9) gebildete Meßebene zur Auflage der Flächenware vorgesehen ist.

2. Vorrichtung nach Anspruch 1, **dadurch gekennzeichnet, daß** die NMR-MOUSE-Sonden (9a, 9b, 9c) in der Meßebene sich gegenseitig überlappend angeordnet sind.

3. Vorrichtung nach Anspruch 2, **dadurch gekennzeichnet, daß** die NMR-MOUSE-Sonden (9a, 9b, 9c) sich hinsichtlich ihrer meßempfindlichen Volumenbereiche (35, 36, 37) überlappend angeordnet sind.

4. Vorrichtung nach einem der vorhergehenden Ansprüche, **dadurch gekennzeichnet, dass** zur Untersuchung von Flächenware mit parallel verlaufenden Festigkeitsträgern die NMR-MOUSE-Sonden (9a, 9b, 9c) in der Meßebene benachbart angeordnet und nebeneinander senkrecht zum Verlauf der Festigkeitsträger ausgerichtet sind.

5. Vorrichtung nach einem der vorhergehenden Ansprüche, **dadurch gekennzeichnet, daß** zur Analyse schlauchförmiger Flächenware ein zylindrischer Meßkörper (1) mit zylindrischer Meßebene und ringförmig angeordneten NMR-MOUSE-Sonden (9) vorgesehen ist.

6. Vorrichtung nach einem der vorhergehenden Ansprüche, **dadurch gekennzeichnet, dass** die NMR-MOUSE-Sonden derart ausgebildet sind, dass sie zur Untersuchung warmer Flächenware geeignet sind, wobei die Höhe der Temperatur der Flächenware von der Curie-Temperatur des Sondenmaterials begrenzt ist.

7. Vorrichtung nach einem der vorhergehenden Ansprüche, **dadurch gekennzeichnet, daß** die NMR-MOUSE-Sonden wechselweise ansteuerbar ausgebildet sind.

## Claims

1. A device for inspecting flat goods made of polymeric materials with embedded textile strength supports, **characterised in that** a measurement plane formed by NMR MOUSE sensors (9) is provided on a measurement element (1, 2) on which flat goods may be supported for nuclear magnetic analysis of the flat goods.

2. The device according to claim 1, **characterised in that** the NMR MOUSE sensors (9, 9b, 9c) are arranged so that they overlap one another on the measurement plane.

3. The device according to claim 2, **characterised in that** the NMR MOUSE sensors (9, 9b, 9c) are arranged so that they overlap one another with respect to the volume areas (35, 36, 37) thereof that are sensitive for measurement purposes.

4. The device according to any of the preceding claims, **characterised in that** for purposes of inspecting flat goods with strength supports extending in parallel, the NMR MOUSE sensors (9, 9b, 9c) are arranged adjacently in the measurement plane and are aligned adjacently and perpendicular to the course of the strength supports.

5. The device according to any of the preceding claims, **characterised in that** a cylindrical measurement element (1) having a cylindrical measurement plane and circularly arranged NMR MOUSE sensors (9) is provided for purposes of analysing tubular flat goods.

6. The device according to any of the preceding claims, **characterised in that** the NMR MOUSE sensors are configured in such manner that they are suitable for analysing warm flat goods, the upper limit of the temperature of the flat goods being defined by the Curie temperature of the sensor material.

7. The device according to any of the preceding claims, **characterised in that** the NMR MOUSE sensors are configured so that they may be controlled in alternating sequence.

## Revendications

1. Dispositif pour examiner des articles plats à base de matériau polymère comportant des supports de résistance textiles enrobés, **caractérisé en ce que**, pour l'analyse magnétique nucléaire de l'article plat sur un corps de mesure (1, 2), il est prévu un plan de mesure formé par des sondes NMR-MOUSE (9) pour le support de l'article plat.

2. Dispositif selon la revendication 1, **caractérisé en ce que** les sondes NMR-MOUSE (9a, 9b, 9c) sont disposées dans le plan de mesure en se chevauchant réciproquement.

3. Dispositif selon la revendication 2, **caractérisé en ce que** les sondes NMR-MOUSE (9a, 9b, 9c), sont disposées en se chevauchant en ce qui concerne leurs plages de mesure (35, 36, 37) sensibles à la mesure.

4. Dispositif selon l'une quelconque des revendications précédentes, **caractérisé en ce que**, pour examiner des articles plats avec des supports de résistance agencés de façon parallèle, les sondes NMR-MOUSE (9a, 9b, 9c) sont disposées dans le plan de mesure à proximité les unes des autres et sont orientées les unes à côté des autres perpendiculairement au tracé des supports de résistance.

5. Dispositif selon l'une quelconque des revendications précédentes, **caractérisé en ce que**, pour analyser des articles plats en forme de flexible, il est prévu un corps de mesure (1) cylindrique avec un plan de mesure cylindrique et des sondes NMR-MOUSE (9) disposées en cercle.

6. Dispositif selon l'une quelconque des revendications précédentes, **caractérisé en ce que** les sondes NMR-MOUSE sont conçues de telle façon qu'elles sont examiner des articles plats chauds, le niveau de la température de l'article plat étant limité par la température de Curie du matériau de sonde.

7. Dispositif selon l'une quelconque des revendications précédentes, **caractérisé en ce que** les sondes NMR-MOUSE sont réalisées de façon à pouvoir être activées à tour de rôle.
